(19)

Europäisches Patentamt
European Patent Office
Office européen des brevets

(11) **EP 2 793 040 A1**

(12) **EUROPEAN PATENT APPLICATION**

(43) Date of publication:
**22.10.2014 Bulletin 2014/43**

(51) Int Cl.:
*G01R 33/48* (2006.01)          *G01R 33/565* (2006.01)

(21) Application number: **13164530.1**

(22) Date of filing: **19.04.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Universitätsklinikum Jena**
**07743 Jena (DE)**

(72) Inventors:
• **Krämer, Martin**
  **07749 Jena (DE)**
• **Reichenbach, Jürgen R.**
  **07743 Jena (DE)**

(74) Representative: **Schulz, Ben Jesko**
**Schulz Junghans**
**Patentanwälte PartGmbB**
**Chausseestraße 5**
**10115 Berlin (DE)**

(54) **Method for processing phase information, particularly for susceptibility weighted imaging, obtained from PROPELLER measurements**

(57) The present invention relates to a method for processing phase information, particularly for susceptibility weighted imaging, obtained from PROPELLER measurements, comprising the steps: acquisition (1) of MR signals using a PROPELLER acquisition scheme, wherein MR signals are acquired for a plurality of k-space blades (20), wherein each k-space blade (20) comprises a central region (22) of the k-space and wherein adjacent k-space blades (20) are rotated in k-space with respect to each other about said central region (22) by a predefined angle (A), and applying a post-processing step (8) to the MR signals which alters the phase information of the MR signals. According to the invention - before applying said post-processing step (8) to said MR signals - a phase-processing step (3, 4, 5, 6, 7) is applied to the MR signals of each k-space blade (20), wherein said phase-processing step (3, 4, 5, 6, 7) utilizes the unaltered phase information of the MR signals of the k-space blades (20), particularly for enhancing a contrast in an MR image reconstructed from the MR signals. Therefore, applying the present invention, phase information acquired by a PROPELLER sequence can be preserved and utilized for various purposes (e.g. susceptibility weighted MRI, phase contrast MRI, etc).

Figure 1

**Description**

The present invention relates to a method and a computer program for processing phase information, particularly for susceptibility weighted imaging (but not restricted thereto), obtained from PROPELLER Magnetic Resonance Imaging (MRI) measurements.

Magnetic Resonance Imaging (MRI), or nuclear magnetic resonance imaging (NMRI), or magnetic resonance tomography (MRT) is a well-known medical imaging technique that is used to visualize internal structures of the body. MRI makes use of the property of nuclear magnetic resonance (NMR) of nuclear spins, particularly those of Hydrogen.

The method according to the present invention deals with the utilization of phase information from complex-valued MRI-data, which have been acquired using PROPELLER / BLADE /MultiVane trajectories.

Here, PROPELLER is an acronym for Periodically Rotated Overlapping ParallEL Lines with Enhanced Reconstruction. The notions BLADE and MultiVane refer to the same acquisition scheme. In the following we will refer to these acquisition schemes as PROPELLER.

Usually, in such methods, particularly complex-valued MR signals are acquired using such a PROPELLER acquisition scheme, wherein MR signals are acquired for a plurality of so called k-space blades, wherein particularly each k-space blade comprises a central region of k-space (e.g. around the center of k-space), and wherein particularly adjacent k-space blades are arranged at a pre-defined angle in k-space with respect to each other that corresponds to a rotation of said k-space blades by said pre-defined angle about said central region. Further, usually at least one processing step that is here denoted as post-processing step is applied to the MR signals, which alters the phase information of the particularly complex-valued MR signals (data).

Processing of phase information in MRI is usually carried out in applications for determination and quantification of the spatial distribution of the magnetic susceptibility of biological samples. Phase information in MRI is also employed for separating spatial distributions of fat and water in tissue components.

Other fields of application comprise MRI-based phase contrast angiography for quantitative estimation of flow velocities or phase information based MRI-thermometry.

It is known that PROPELLER acquisition schemes provide an optimized segmentation of the spatial frequency space (or k-space), as the PROPELLER scheme samples segments in k-space which consist of periodically rotated strips (or k-space blades), each of said k-space blades comprising a central region of k-space, whereby motion artifacts in the MR image can be reduced to large extent in subsequent correction steps [10].

It is also known, that prior to the combination of the acquired k-space blades a correction has to be made accounting for potential offsets / shifts between the blades, e.g. due to imprecisions and errors in scanner hardware of the MRI apparatus, correcting the k-space blades such that they constructively interfere [12].

In order to secure a constructive interference of the blades it is known that the phase of the MR signals of the k-space blades might be altered during reconstruction of the MR image, which leads to the modification or complete destruction of the phase information, rendering a further processing of phase information futile [13, 10].

Furthermore a method for correcting phase data is known, which allows reconstructing MRI images acquired from PROPELLER acquisition schemes such that the phase information can be preserved even after combining the individual k-space blades [11].

It is also known that by acquiring additional measurement data reference information can be obtained, which allow for conducting an adapted correcting of the image phase such that even after combination of the k-space blades the phase information can be preserved [14].

However, all of the above-cited technical teachings utilize a correction scheme for the phase information that is carried out prior to combining the MR signals of the individual k-space blades. Apart of how the phase correction is carried out it is evident that any correcting step always involves an alteration or modification of the measurement data.

Furthermore, the quality of the reconstructed MR images depends strongly on the quality of the phase correction. An insufficient correction of the phase data prior to the combination of the k-space blades might lead to artifacts in the reconstructed MR images. This is a disadvantage of the methods described in [11, 14] as these methods generate parameters for the phase correction to be performed on the basis of the measurement or reference data. Deviations or imprecisions of these parameters may result in errors in the phase correction.

The problem underlying the present invention therefore is to process phase information being acquired with help of PROPELLER trajectories (i.e. k-space blades), particularly using an arbitrary kind of readout, such that unaltered phase information is utilized.

This problem is solved by the method having the features of claim 1. Preferred embodiments are stated in the sub claims. Further, the problem underlying the present invention is solved by a computer program having the features of claim 9.

According to claim 1, prior to applying any (post)-processing step to said particularly complex-valued MR signals that alters or modifies the phase information, a phase-processing step is applied to the MR signals of each k-space blade, wherein said phase-processing step utilizes the unaltered phase information of the MR signals of the k-space blades, particularly for enhancing a contrast in an MR image reconstructed from the MR signals.

Here, particularly, processing steps that are carried out prior to said phase-processing step are denoted as pre-processing steps, while post-processing step means processing steps that are carried out after said phase-processing step. A step may comprise several procedures.

Particularly, in other words, the invention adapts the reconstruction of MR signals or data acquired by means of PROPELLER trajectories (k-space blades) in a way that the processing of phase information is carried out on the basis of the MR signals of the individual k-space blades prior to the combination of the MR signals of the individual k-space blades, but after eventually necessary pre-processing steps that do not alter phase information, such that said phase-processing step takes place prior to the processing steps that alter or correct the phase information, as described above, in any regard, and combine the PROPELLER segments (i.e. k-space blades). Particularly, the specific processing of the unmodified phase information of the individual k-space blades is carried out after a two- or three-dimensional Fourier transformation of the individual k-space blades into image space by means of an arbitrary method for processing the available phase- and magnitude information either independently with respect to each other or in the form of an arbitrarily combined processing of phase- and magnitude information. Thereafter, a two- or three-dimensional (e.g. Fast) Fourier transformation is carried out, after which the resulting phase-processed MR signals of the individual k-space blades run through all remaining (post)-processing steps of the data/image reconstruction.

Applying the claimed method, phase information acquired by a PROPELLER acquisition scheme resulting in MR signals represented as k-space blades can be utilized prior to altering such information in any way due to further processing steps.

Due to the direct processing of the unaltered phase information the claimed invention features an increased robustness against MR image artifacts when compared to [11] and [14], since - after a processing of the unaltered phase information has taken place - the phase information can be altered almost arbitrarily, so that the more robust methods for correcting phase information described in e.g. [10, 13] can be applied. A further advantage of the present invention is that - insofar after the phase information processing step no complex-valued data is present - a phase correction step can be omitted upon conduction of the remaining processing steps of data reconstruction, since in the case of real-valued data a constructive interference of k-space blades after the two- or three-dimensional inverse (e.g. Fast) Fourier transformation is ensured.

Particularly, the present invention is independent from the particular way of how the PROPELLER trajectories (also denoted as k-space blades) are recorded / read out. Further, the invention is independent from the way phase information is processed on down-stream data processing steps.

Further, particularly, the method according to the invention is suited for processing phase information, particularly for susceptibility weighted imaging (SWI), obtained from PROPELLER MRI measurements. However, the method is not restricted to SWI.

Further, particularly, the field of application of the present invention relates to all magnetic resonance (MR) tomographic acquisition schemes, which utilize PROPELLER.

An MR signal has its origin in a radio frequency (MHz) signal (RF signal) emitted from the sample and recorded by an MRI apparatus, wherein the RF signal is subsequently processed such that it is assigned to a particularly complex valued point or line in k-space. Particularly, in the framework of the present invention, the acquisition of the MR signals means the acquisition with help of an MR apparatus or providing the MR signal as data that can be read by a computer program when executed on a suitable computer.

In a preferred embodiment of the present invention, the MR signals of the individual k-space blades are combined and undergo a Fourier transformation in said post-processing step for reconstruction of a final MR image. In the framework of the present invention, a Fourier transformation can be a so-called Fast Fourier Transformation (FFT), and, depending on the specific needs, the Fourier transformation can be (one-, two-, or three-dimensional).

Further, in a preferred embodiment of the present invention, the phase-processing step comprises carrying out a Fourier transformation of the MR signals of each k-space blade into a corresponding particularly complex-valued low-resolution image followed by a phase information processing procedure for each such image, followed by an inverse Fourier transformation of the processed images back to k-space yielding modified MR signals, which are subsequently further processed in said post-processing step.

Particularly, said phase information processing procedure comprises the steps of

- particularly high-pass filtering of said particularly complex valued low-resolution images, particularly for omitting truncation artifacts, particularly due to the Gibbs effect caused by said Fourier transformation, particularly by applying a Hanning window function, Hamming window function, or Blackman window function to said images,

- generating a phase image from each of said, particularly high-pass filtered, images by assigning to each pixel of the respective phase image the phase value of a corresponding particularly complex-valued pixel of the associated particularly high-pass filtered complex-valued low-resolution image,

- generating a magnitude image from each of said images by assigning to each pixel of the respective magnitude image the absolute value (also denoted as magnitude) of the complex-valued value of a corresponding pixel of the associated image, and

- generating from each phase image a corresponding phase mask, containing real-valued pixel values, particularly in the range between 0 and 1, and

- multiplying each phase mask at least once with the corresponding magnitude image, wherein each value of the pixels of the respective phase mask is multiplied at least once with the value of the corresponding pixel of the corresponding magnitude image, whereas such a procedure is also called susceptibility weighted imaging as this kind of combining the various images leads to a final MR image, which features a contrast based on the spatial distribution of the susceptibility of the sample.

It is noted that the phase value of a pixel is the phase value of the particularly complex-valued value as stored in said pixel. The same notion is used for the absolute value.

Furthermore, it is noted that the term pixel may include the meaning of a voxel as well. A voxel is a volume element, representing a value on a grid in three dimensions. This is analogous to a pixel, which situates a value in two dimensions.

The phase of a complex-valued value comprising a real part (Real) and an imaginary part (Imag) is given by the arctangent of the quotient of imaginary and real part

$$phase = atan(Imag/Real),$$

whereas the magnitude or absolute value of a complex-valued value is given by the square root of the sum of the squared real part and the squared imaginary part

$$abs = \sqrt{(Real^2 + Imag^2)}.$$

The term magnitude image therefore refers to MR images which are generated by assigning each pixel of the magnitude image the absolute value, whereas the complex-valued values are provided by the particularly complex valued image pixels of the Fourier Transformation of the MR signals as stored in the k-space blades.

Phase image pixels therefore contain the phase as pixel values, which are derived from the Fourier transformation of the MR signals of the k-space blades.

The phase mask is for example given by a continuous function assigning the phase values of the phase image to a range between 0 and 1. Furthermore, said continuous function is particularly monotonic, either increasing or decreasing, or constant, whereas the particularly freely selectable phase value of interest is assigned particularly the value 0 in the phase mask, particularly to suppress those pixels that have this certain phase value [4].

Further, according to a notably preferred embodiment of the present invention, prior to applying said phase-processing step, the MR signals are not processed in a way that their phase information is altered (see above).

Further, in a preferred embodiment of the present invention, a pre-processing step is applied to the MR signals of the k-space blades before the phase-processing step, particularly comprising at least one of:

- in case said acquisition scheme further uses bipolar echo planar imaging (EPI) applying a ghost correction to the MR signals of the k-space blades in order to reduce ghost artifacts in the resulting MR image, and/or

- reconstructing missing MR signals of missing k-space lines of a k-space blade particularly by means of a k-space based parallel MRI reconstruction method, e.g. GRAPPA.

As MRI utilizes specific RF pulse and magnetic gradient sequences there are a number of different acquisition techniques utilizing different such sequences. Usually, a single RF pulse is used to probe a certain segment or line of the k-space. An echo-planar imaging (EPI) sequence however uses a single RF pulse to acquire an entire MR image (single-shot technique). Therefore EPI is a comparably fast MR imaging technique. EPI might be able to acquire an entire series of MR images in the same time a conventional fast pulse sequence generates a single MR image. Therefore, EPI is a preferred technique when aiming to reduce imaging time, decreasing motion artifacts, or to image rapid physiologic processes particularly of the human body. Furthermore, in bipolar EPI a readout magnetic field gradient is switched in bipolar fashion when acquiring the MR signals, as described in [15].

Such MRI acquisition schemes are prone to artifacts which might lead to so-called ghost images. A ghost image is a copy of a part or the entire image, which is overlaid on the image but usually laterally shifted, particularly rotated or flipped and weaker in intensity. Upon visual inspection of the image these additional structural ghost-features in the image are called ghost image. The origins of ghost images are manifold (e.g. motion during acquisition, physiological pulsation) and most of them can be corrected either by adapting the measurement scheme or by correcting after acquisition of the MR signals.

Furthermore, as the k-space is sampled in a line-wise manner (along one-dimensional trajectories) by exposing the sample to a certain pulse sequence, a two-dimensional blade-shaped sampling of k-space may therefore undersample MR signals of the two-dimensional blade. Then, gaps between adjacent sampling trajectories may eventually be filled with values in order to achieve a more densely sampled data set of MR signals.

There exist several such k-space based parallel MRI reconstruction methods to reconstruct these missing MR signals as described in [16]. A technique of particular interest in this context is termed GRAPPA, which stands for GeneRalized Autocalibrating Partially Parallel Acquisitions.

Further, in a preferred embodiment of the invention, the post-processing step further comprises at least one of:

- distortion correction of the MR signals of the k-space blades,

- motion correction of the k-space blades,

- phase correction of the MR signals of the k-space blades, wherein particularly the individual MR signal containing k-space blades are combined and transformed by a Fourier transformation to yield a final MR image, particularly featuring enhanced image contrast.

As there are a number of potential distortion artifacts originating from various kinds of reasons (e.g. hardware imprecision, chemical shifts, magnetic field distortions, etc.), a distortion correction aiming to compensate for these distortions is applied to the MR signals of the k-space blades, see e.g. [9] and references therein.

Also motion during acquisition is affecting image quality in MRI imaging. Motion might lead to ghost images and other artifacts. Despite the PROPELLER acquisition scheme utilizing particularly EPI, a post-processing step might still compensate for motion during acquisition [10]. As mentioned above also phase correction as described in [11] might be applied.

Furthermore, the problem underlying the present invention is solved by a computer program claimed in claim 9 for conducting the method according to the invention when the computer program is executed or runs on a suitable computer. In the context of this computer program according to claim 9, the feature of claim 1 according to which "acquisition of MR signals using a PROPELLER acquisition scheme, wherein MR signals are acquired for a plurality of k-space blades" is conducted, means that the computer program is designed to read in (or process) MR signals that have been acquired using a PROPELLER acquisition scheme, wherein MR signals are acquired for a plurality of k-space blades.

In the following, embodiments of the present invention shall be described with reference to the Figures, wherein

Fig. 1    shows a flow chart of a method according to the invention;

Fig. 2    shows a schematical view of k-space blades also denoted as PROPELLER, BLADE or MultiVane trajectories;

Fig. 3    shows a schematic view of an individual k-space blade;

Fig. 4    shows a transverse layer of an MR signal in image space, wherein the phase information was made utilizable by means of a method according to the invention;

Fig. 5    shows a further flow chart of the method according to the invention;

Fig. 6    shows 2D Fourier transformed low resolution single blade data of magnitude (left), SWI (middle) and single channel phase (right); and

Fig. 7    shows reconstructed images, namely magnitude images (top), susceptibility weighted images (middle), and mean intensity projection averaged over 3 slices (bottom).

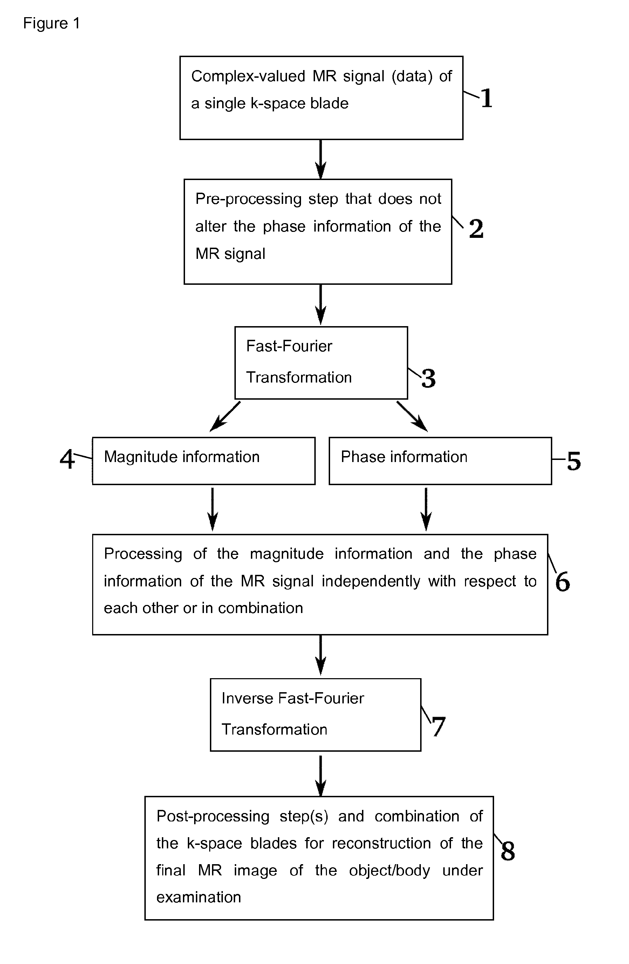

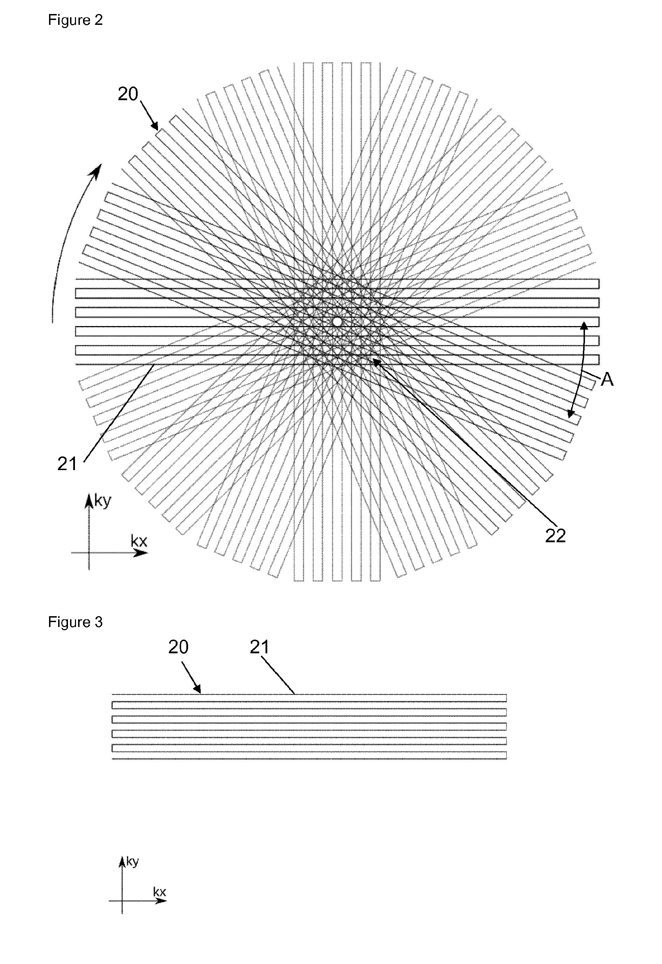

Fig. 1 shows a signal flow diagram of a method according to the invention for the harnessing of phase information from MRI data acquired with so called PROPELLER trajectories or k-space blades, whose possible orientation and shape in k-space are shown schematically in Fig. 2

The PROPELLER (periodically rotated overlapping parallel lines with enhanced reconstruction technique) represents a radial scanning method, which is for instance described in detail in [10]. In this acquisition scheme, the scanning of k-space is done for a plurality of so called k-space blades 20 (cf. Fig. 2). I.e. MR (Magnetic Resonance) signals are acquired in k-space in N such blades 20 (e.g. N=8 in Fig. 2) consisting of L (e.g. equidistant) parallel phase encoding lines 21 (e.g. corresponding to the L lowest frequency phase-encoding lines in a Cartesian k-space sampling scheme) wherein in Figs. 2 and 3 one has e.g. L=10. Each blade 20 is rotated in k-space by an angle of A=180°/N, so that the total data set (MR signals) approximately takes the shape of a circle in k-space. As can be seen from Fig. 2, in comparison with other acquisition techniques in MRI, the PROPELLER technique has the advantage that with each k-space blade 20 a central circular region 22 of k-space is sampled having a diameter L. This central region in k-space around the center of k-space can be used to reconstruct a low-resolution image for each k-space blade 20. These low-resolution images (or corresponding representations in k-space), are preferably compared to each other in order to remove in-plane displacements, which are due to a motion of the examined patient or object/body under examination. Further, in order to determine which k-space blades 20 are acquired with a through-plane displacement, a suitable technique using e.g. cross-correlation may be employed.

When the MR signals of the individual blades are combined in k-space before the reconstruction of the final MR image, said displacements can be taken into account. I.e., the comparison of two different k-space blades 20 with regard to the MR signals of the central region allows movements of the patient/object under examination to be determined that occur between the acquisition of said two k-space blades 20. This movement information can then be taken into account in the PROPELLER image reconstruction using all measured raw data, so that it is possible to end with nearly movement-free images. Further MR signals (data) from k-space blades 20 with the least amount of through-plane motion may be used in said regions where the k-space blades 20 overlap, so that artifacts arising from through-plane motion are reduced. Summarizing, the PROPELLER technique oversamples said central portion 22 of k-space so as to provide for an MR image acquisition scheme that is robust with respect to motion of the examined object/body during MR signal acquisition, see e.g. [11, 12].

However, the orientation of the k-space blades (e.g. along the long or short axis), the manner in which the data is acquired on the individual k-space blade (or PROPELLER or MultiVane trajectory), which can be read e.g. by the well-known echo planar, turbo spin-echo, spin-echo or gradient-echo imaging, as well as the dimensions of the data (2-dimensional or 3-dimensional) do not play a role for the applicability of the invention insofar the reconstruction of the measuring data for generating the final MR image of an object (e.g. body portion) to be imaged requires performing a phase correction of the data.

Data (MR signals) 1 (see Fig. 1) of a single PROPELLER segment or k-space blade, shown schematically in a possible orientation and shape in Fig. 3 are processed by known processing steps 2 of data reconstruction and further pre-processed when necessary, so that the phase information of the individual k-space blade can be processed in a phase-processing step 3, 4, 5, 6, 7 without having been modified by one of the preceding data pre-processing steps 2. The data obtained from a 2-dimensional or 3-dimensional Fourier transform 3, preferably Fast Fourier Transform, comprises magnitude 4 and phase information 5, which in the next processing step 6 is either independently processed or in combination (using both magnitude 4 and phase data 5) in an e.g. arbitrary manner, e.g. according to specific needs, say for enhancing image contrast using SWI or another procedure for improving e.g. image quality.

After processing of the magnitude and / or phase information according to the applied processing method complex or real-valued data is generated to which an inverse 2-dimensional or 3-dimensional Fourier transformation (particularly Fast Fourier Transformation) 7 is applied. Thereafter, the data then runs through the remaining data post-processing steps 8.

The further data post-processing steps 8 may not only include the combination of the individual PROPELLER segments (k-space blades), but also a phase correction or adjustment - insofar still necessary after the previous processing of magnitude and phase information 6 - for centering the individual k-space blades before combination of the k-space blades so as to yield the final MR image.

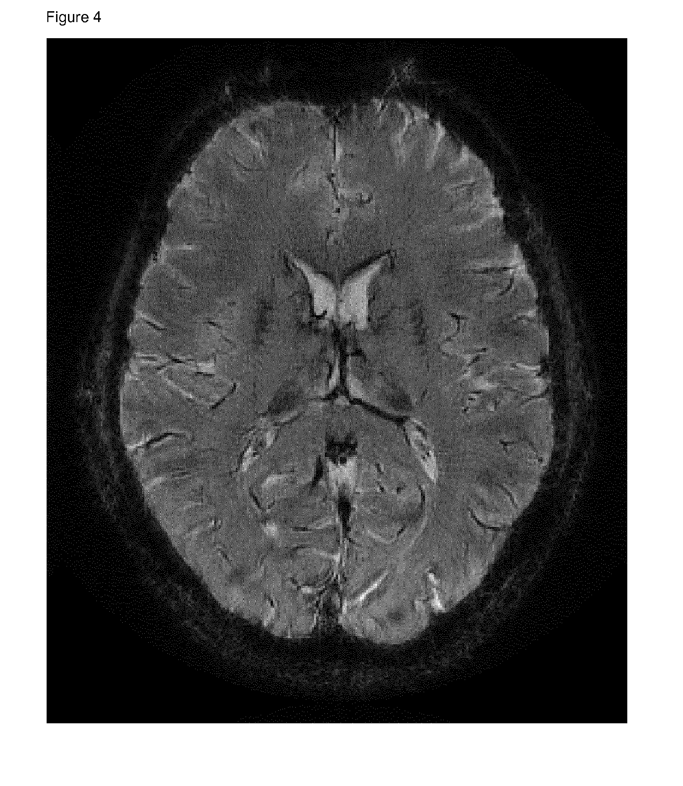

In a specific embodiment of the invention the processing 6 of the magnitude 4 and phase information 5 may be combined by known methods for the determination of the magnetic susceptibility, whereby the magnitude- 4 and phase information 5 are combined to real-valued susceptibility-weighted data. After a 2-dimensional inverse fast Fourier transformation 7 of the PROPELLER or k-space blades processed in this manner, a susceptibility-weighted final MR image of the examined object is created by the combination of the individual PROPELLER segments or k-space blades 8, as shown in Fig. 4. This is denoted as SWI (susceptibility-weighted imaging).

Example:

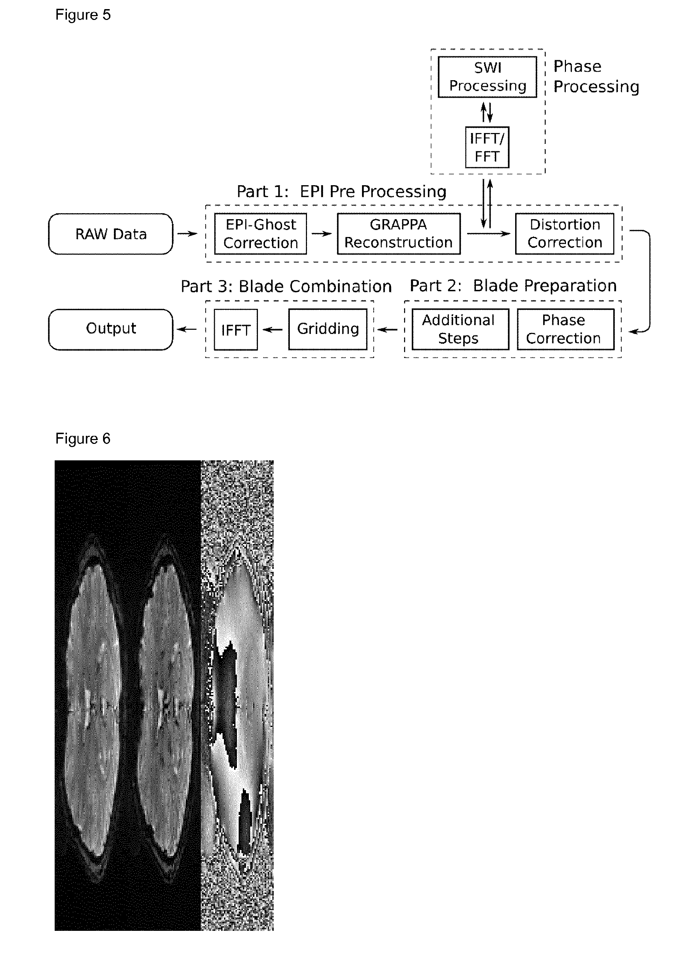

A further example is described below in conjunction with Figs. 5 to 7.

Fast high resolution $T_2$*-weighted imaging using periodically rotated overlapping parallel lines with enhanced reconstruction - echo planar imaging (PROPELLER-EPI) [1,2] requires phase correction during image reconstruction. As a result, only modified phase information is obtained which prevents applying processing techniques that rely on accurate phase measurements, such as susceptibility weighted imaging (SWI) [3,4] or quantitative susceptibility mapping (QSM) [5]. In this example, a PROPELLER-EPI reconstruction technique is proposed for processing phase images on the blade level before applying the standard PROPELLER-EPI reconstruction. This modified reconstruction pipeline enables creating susceptibility weighted images based on data acquired with a fast high-resolution PROPELLER-EPI sequence.

With each RF-excitation only a narrow blade 20 around the k-space centre is acquired in a very short time (cf. also Fig. 2 and 3). With the following excitations this blade is continuously rotated until the entire k-space has been covered. Because of the reduced readout length for each blade 20 the negative effects of $T_2$*-decay are significantly reduced. If an extended time series is measured by continuously acquiring a large number of blades 20 it is possible to reconstruct a new image with each acquired blade 20 by using a sliding-window reconstruction [3]. This acquisition scheme makes the sequence a multi-shot method, which however has the advantage that the k-space centre is sampled with each shot.

PROPELLER-EPI samples narrow blades 20 which are subsequently rotated around the center of the k-space. To ensure a constructive data combination when combining the blades 20, a phase correction by filtering or complete removal of phase information in image space is typically employed. Additionally, depending on the used method for geometric distortion correction image phase can be further modulated or even removed. In order to reconstruct susceptibility weighted images processing is performed on a blade level according to the invention, before image phase is modified in any way. The extended reconstruction scheme is shown in Fig. 5.

Images were acquired on a clinical 3T system (TIM Trio, Siemens) using a high resolution PROPELLER-EPI sequence with acquisition matrix size of 320 x 50 voxels for each blade [6]. With 2 times GRAPPA acceleration a total of 25 lines in phase encoding direction were measured. 40 2D slices were acquired with a thickness of 2.5 mm and no gap between slices. Other acquisition parameters were: TE/TR/FA = 34 ms / 3800 ms/ 87°. To reduce $T_2^*$ signal drop outs and geometric distortions originating from the nasal cavities transverse slices were angled by 20° towards coronal orientation. For correction of geometric distortions field maps were acquired using a multi-echo gradient echo PROPELLER sequence. Based on the field maps distortion correction was applied on the blade level prior to blade combination using a multi-frequency reconstruction [7]. For an improved signal-to-noise ratio (SNR) a total of 3 averages were acquired.

Fig. 5 shows a flow chart of an exemplary embodiment of a modified POPELLER-EPI reconstruction scheme according to the invention used in the present example. By inverse Fourier transforming the single blades after EPI ghosting correction and GRAPPA reconstruction, but prior to distortion and phase correction, complex-valued low-resolution images with unmodified phase information are obtained. For each low resolution complex-valued image SWI reconstruction was performed using high-pass filtering (inverse Hanning window with 160 x 50 voxels in read and phase encoding dimensions, respectively) and subsequent multiplication (6 times) of the weighted high-pass filtered phase images with the corresponding magnitude [3,4]. After SWI processing the susceptibility weighted images were Fourier transformed back to k-space undergoing the remaining steps of the PROPELLER-EPI reconstruction, namely distortion correction compensating geometrical distortions due to the EPI acquisition, phase correction for removing ghosting artifacts originating from the bipolar EPI acquisition, particularly additional steps, such as motion correction, (e.g. 2D) gridding to interpolate the rotated blades/data points onto a rectangular (e.g. Cartesian) grid (blade combination to a single k-space/image), as well as IFFT (inverse Fast Fourier Transform) for yielding the final MR image in image space. Fig. 6 now shows the 2D Fourier Transformed low resolution single blade data of magnitude (left), SWI (middle) and single channel phase (right) before distortion correction and blade combination (cf. Fig. 5). Single blade k-space data was directly Fourier transformed without zero filling to a symmetric matrix size.

Results

SWI processing of low resolution blade data performed well even when applied on the blade level with a data matrix size of only 320 x 50 (Fig. 6). Unmodified single channel phase (Fig. 6 right) data was used for SWI reconstruction (Fig. 6 middle). By gridding the Fourier transformed SWI data from multiple blades full resolution images could be reconstructed (cf. Fig. 5).

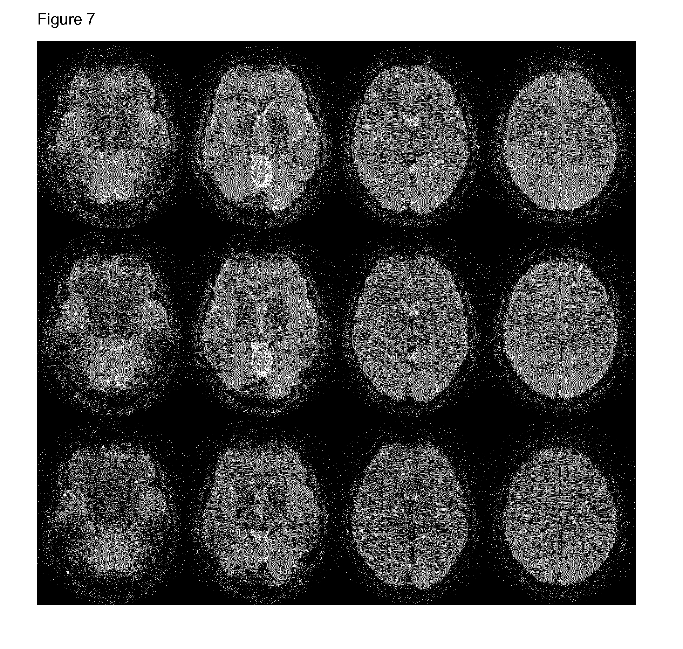

PROPELLER-EPI images reconstructed using SWI processing provided the typical susceptibility weighted contrast (Fig. 7, middle row) with enhanced venous vessels and increased image contrast in iron-laden tissue such as the globus pallidus, putamen and other deep gray matter regions. Resolution of the acquired PROPELLER-EPI images was high enough to depict even small structures such as subependymal veins. Mean intensity projection images (Fig 7, bottom row) further increased the delineation of vessel.

Performing SWI processing on the blade level in PROPELLER-EPI image reconstruction enables harnessing of image phase information which is otherwise lost during the original reconstruction process. Images with a typical susceptibility weighted contrast were obtained with the same high spatial resolutions previously achieved with PROPELLER-EPI [6]. Once field maps have been acquired the proposed technique allows rapid acquisition of susceptibility weighted images.

Even though a fast EPI readout is used the PROPELLER segmentation scheme allows for a robust acquisition of high resolution images.

PROPELLER-EPI has already been shown to be well suited for functional magnetic resonance imaging (fMRI) [2] acquiring high spatial resolution with repetition times suitable for functional experiments.

Here, PROPELLER-EPI is used to perform functional SWI with potentially increased sensitivity compared to conventional fMRI due to the incorporation of phase information.

Furthermore, the presented framework allows in a similar fashion as presented here the implementation of more sophisticated phase-processing algorithms such as quantitative susceptibility mapping (QSM) [5]. Finally, using dynamic geometric distortion correction without static field map acquisition (e.g. PLACE [8] or reversed gradient method [9]) would significantly reduce scan time. Without pre-scans the technique could be extended for performing susceptibility weighted imaging of non-stationary objects, e.g. allowing application to abdominal imaging.

**References**

[1] Wang FN, Huang TY, Lin FH, Chuang TC, Chen NK, Chung HW, Chen CY, Kwong KK. PROPELLER EPI: An MRI technique suitable for diffusion tensor imaging at high field strength with reduced geometric distortions. Magn. Reson. Med 2005: 54(5):1232-1240,

[2] Krämer M, Jochimsen TH, Reichenbach JR. Functional magnetic resonance imaging using PROPELLER-EPI. Magn Reson Med 2012; 68(1):140-151

[3] Reichenbach JR, Haacke EM. High-resolution BOLD venographic imaging: a window into brain function. NMR Biomed 2001; 14: 453-467

[4] Haacke EM, Xu Y, Cheng YCN, Reichenbach JR. Susceptibility Weighted Imaging (SWI), Magn Reson Med 2004; 52: 612-618

[5] Schweser F, Deistung A, Lehr BW, Reichenbach JR. Quantitative imaging of intrinsic magnetic tissue properties using MRI signal phase: An approach to in vivo brain iron metabolism? NeuroImage 2011; 54: 2789-2807

[6] Krämer M, Reichenbach JR. Submillimeter fMRI at 3T Using Long Axis PROPELLER-EPI. Proc. ISMRM 2012, #2862.

[7] Man LC, Pauly JM, Macovski A. Multifrequency interpolation for fast off-resonance correction. Magn Reson Med 1997, 37(5):785-792.

[8] Xiang QS, Ye FQ. Correction for geometric distortion and N/2 ghosting in EPI by phase labeling for additional coordinate encoding (PLACE). Magn Reson Med 2007, 57(4):731-741.

[9] Holland D, Kuperman JM, Dale AM. Efficient correction of inhomogeneous static magnetic field-induced distortion in Echo Planar Imaging. NeuroImage 2010; 50(1):175-183.

[10] Pipe JG. Magnetic Resonance Motion correction with PROPELLER MRI: application to head motion and free-breathing cardiac imaging. Magn Reson Med 1999; 42(5):963-969

[11] Eggers E. PROPELLER MRI with Phase Correction, US 2010/0117645 A1.

[12] Stemmer A. MR Image Reconstruction Method and MR Apparatus using PROPELLER Imaging, US 2006/0264735 A1.

[13] Skare S, Newbould RD, Clayton DB, Bammer R. Propeller EPI in the Other Direction, Magn Reson Med. 2006, 55(6), 1298-1307;

[14] Huo D, Li Z, Aboussouan E, Karis JP, Pipe JG.

Turboprop IDEAL: A Motion-Resistant Fat-Water Separation Technique, Magn Reson Med, 2009, 61(1), 188-195

[15] Poustchi-Amin M, Mirowitz SA, Brown JJ, McKinstry RC, Li T. Principles and Applications of Echo-planar Imaging: A Review for the General Radiologist. Radiographics 2001, 21, 767-779.

[16] Blaimer M, Breuer F, Mueller M, Heidemann RM, Griswold MA, Jakob PM. SMASH, SENSE, PILS, GRAPPA - How to Choose the Optimal Method, Top Magn Reson Imaging. 2004; 15(4): 223-236

**Claims**

1. Method for processing phase information, particularly for susceptibility weighted imaging, obtained from PROPELLER measurements, comprising the steps:

   - acquisition (1) of MR signals using a PROPELLER acquisition scheme, wherein MR signals are acquired for a plurality of k-space blades (20), wherein particularly each k-space blade (20) comprises a central region (22) of the k-space, and wherein particularly adjacent k-space blades (20) are rotated in k-space with respect to each other about said central region (22) by a pre-defined angle (A), and
   - applying a post-processing step (8) to the MR signals which alters the phase information of the MR signals,

   **characterized in that**
   before applying said post-processing step (8) to said MR signals, a phase-processing step (3, 4, 5, 6, 7) is applied to the MR signals of each k-space blade (20), wherein said phase-processing step (3, 4, 5, 6, 7) utilizes the unaltered phase information of the MR signals of the k-space blades (20), particularly for enhancing a contrast in an MR image reconstructed from the MR signals.

2. Method according to claim 1, **characterized in that** in said post-processing step (8) the MR signals for the individual k-space blades (20) are combined for reconstruction of a final MR image by an inverse Fourier transformation.

3. Method according to one of the preceding claims, **characterized in that** the phase-processing step comprises carrying out a Fourier transformation (3) of the MR signals of each k-space blade (20) into a corresponding image followed by a phase information processing procedure (4, 5, 6) for each image, followed by an inverse Fourier transformation (7) of the processed images back to k-space yielding modified MR signals, which are subsequently further processed in said post-processing step (8).

**4.** Method according to claim 3, **characterized in that** said phase information processing procedure (4, 5, 6) comprises the steps of

- particularly high-pass filtering of said images, particularly for omitting truncation artifacts, particularly due to the Gibbs effect caused by said Fourier transformation, particularly by applying a Hanning window function, Hamming window function, or Blackman window function to said images,
- generating a phase image from each of said, particularly high-pass filtered, images by assigning to each pixel of the respective phase image the phase value of a corresponding pixel of the associated image,
- generating a magnitude image from each of said images by assigning to each pixel of the respective magnitude image the absolute value of the value of a corresponding pixel of the associated image, and
- generating from each phase image a corresponding phase mask, containing real-valued pixel values, particularly in the range between 0 and 1, and
- multiplying each phase mask at least once with the corresponding magnitude image, wherein each value of the pixels of the respective phase mask is multiplied at least once with the value of the corresponding pixel of the corresponding magnitude image.

**5.** Method according to one of the preceding claims, **characterized in that** prior to applying said phase-processing step (3, 4, 5, 6, 7), the MR signals are not processed in a way that their phase information is altered.

**6.** Method according to one of the preceding claims, **characterized in that** before the phase-processing step (3, 4, 5, 6, 7) a pre-processing step (2) is applied to the MR signals of the k-space blades (20), particularly comprising at least one of:

- in case said acquisition scheme further uses bipolar echo planar imaging applying a ghost correction to the MR signals of the k-space blades (20) in order to reduce ghost artifacts in the resulting MR image, and/or
- reconstructing missing MR signals of missing k-space lines of a k-space blade (20) particularly by means of a k-space based parallel MRI reconstruction method, particularly GRAPPA,

wherein particularly, the pre-processing step (2) does not alter any phase information of the MR signals.

**7.** Method according to one of the preceding claims, **characterized in that** said post-processing step (8) further comprises at least one of:

- distortion correction of the MR signals of the k-space blades (20),
- motion correction of the MR signals of k-space blades (20),
- phase correction of the MR signals of the k-space blades (20), wherein particularly the individual MR signals of the k-space blades (20) are combined and transformed by a Fourier transformation to yield a final MR image, particularly featuring enhanced image contrast.

**8.** Method according to one of the preceding claims, **characterized in that** said phase-processing step (3, 4, 5, 6, 7) comprises carrying out a Fourier transformation (3) of the MR signals of a k-space blade (20) into the image space, as well as carrying out a method for processing available phase information and particularly also magnitude information (4, 5), wherein particularly said phase information and said magnitude information are processed independently from each other or in a combined manner (6), and wherein said phase-processing step (3, 4, 5, 6, 7) further comprises carrying out an inverse Fourier transform (7) of said processed Fourier-transformed MR signals, wherein after performing said inverse Fourier transform (7) an MR image is reconstructed from these inverse-Fourier-transformed MR signals of the individual k-space blades (20).

**9.** Computer program comprising program code for conducting the method according to one of the preceding claims when the computer program is executed on a computer.

Figure 1

Figure 2

Figure 3

Figure 4

Figure 5

Figure 6

Figure 7

Europäisches
Patentamt

European
Patent Office

Office européen
des brevets

# EUROPEAN SEARCH REPORT

Application Number

EP 13 16 4530

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | M KRÄMER ET AL: "Fast Susceptibility Weighted Imaging (SWI) using PROPELLER-EPI", PROCEEDINGS OF THE INTERNATIONAL SOCIETY FOR MAGNETIC RESONANCE IN MEDICINE, 21ST ANNUAL MEETING AND EXHIBITION, SALT LAKE CITY, UTAH, USA, 20-26 APRIL 2013, 7 April 2013 (2013-04-07), page 2499, XP055077900, * the whole document * | 1-9 | INV. G01R33/48 G01R33/565 |
| L | "Call for Papers", , 1 January 2012 (2012-01-01), XP055078044, Retrieved from the Internet: URL:www.ismrm.org/13/call.htm [retrieved on 2013-09-06] * This document was cited in order to prove that the abstract Krämer et al, Proc. ISMRM 2013, p. 2499 was published on 7 April 2013, i.e. before the filing date of the present application.; page 3 * | 1-9 | |
| X | WO 2008/135885 A1 (KONINKL PHILIPS ELECTRONICS NV [NL]; PHILIPS INTELLECTUAL PROPERTY [DE) 13 November 2008 (2008-11-13) * page 3, line 20 - page 4, line 29 * * page 6, line 19 - page 8, line 6 * | 1-3,5-9 | TECHNICAL FIELDS SEARCHED (IPC) G01R |

-/--

The present search report has been drawn up for all claims

| Place of search | Date of completion of the search | Examiner |
|---|---|---|
| Munich | 6 September 2013 | Streif, Jörg Ulrich |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

**EUROPEAN SEARCH REPORT**

Application Number

EP 13 16 4530

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DEVARAJ A ET AL: "An enhanced phase correction algorithm for PROPELLER DW MRI", INTERNATIONAL SOCIETY FOR MAGNETIC RESONANCE IN MEDICINE. SCIENTIFIC MEETING AND EXHIBITION. PROCEEDINGS, INTERNATIONAL SOCIETY FOR MAGNETIC RESONANCE IN MEDICINE, US, 6 May 2006 (2006-05-06), page 2956, XP002495623, ISSN: 1524-6965 * the whole document * ----- | 1-3,5-9 | |
| X | US 7 023 207 B1 (GADDIPATI AJEETKUMAR [US] ET AL) 4 April 2006 (2006-04-04) * column 5, line 15 - column 7, line 26 * ----- | 1-3,5-9 | |

TECHNICAL FIELDS
SEARCHED     (IPC)

The present search report has been drawn up for all claims

| Place of search | Date of completion of the search | Examiner |
|---|---|---|
| Munich | 6 September 2013 | Streif, Jörg Ulrich |

EPO FORM 1503 03.82 (P04C01)

**ANNEX TO THE EUROPEAN SEARCH REPORT
ON EUROPEAN PATENT APPLICATION NO.**

EP 13 16 4530

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2013

| Patent document cited in search report | | Publication date | Patent family member(s) | | Publication date |
|---|---|---|---|---|---|
| WO 2008135885 | A1 | 13-11-2008 | CN | 101680937 A | 24-03-2010 |
| | | | US | 2010117645 A1 | 13-05-2010 |
| | | | WO | 2008135885 A1 | 13-11-2008 |
| US 7023207 | B1 | 04-04-2006 | DE | 102006007969 A1 | 24-08-2006 |
| | | | JP | 5108237 B2 | 26-12-2012 |
| | | | JP | 2006223864 A | 31-08-2006 |
| | | | NL | 1031123 A1 | 17-08-2006 |
| | | | NL | 1031123 C2 | 05-01-2010 |
| | | | US | 7023207 B1 | 04-04-2006 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20100117645 A1
- US 20060264735 A1

### Non-patent literature cited in the description

- **WANG FN ; HUANG TY ; LIN FH ; CHUANG TC ; CHEN NK ; CHUNG HW ; CHEN CY ; KWONG KK.** PROPELLER EPI: An MRI technique suitable for diffusion tensor imaging at high field strength with reduced geometric distortions. *Magn. Reson. Med,* 2005, vol. 54 (5), 1232-1240
- **KRÄMER M ; JOCHIMSEN TH ; REICHENBACH JR.** Functional magnetic resonance imaging using PROPELLER-EPI. *Magn Reson Med,* 2012, vol. 68 (1), 140-151
- **REICHENBACH JR ; HAACKE EM.** High-resolution BOLD venographic imaging: a window into brain function. *NMR Biomed,* 2001, vol. 14, 453-467
- **HAACKE EM ; XU Y ; CHENG YCN ; REICHENBACH JR.** Susceptibility Weighted Imaging (SWI. *Magn Reson Med,* 2004, vol. 52, 612-618
- **SCHWESER F ; DEISTUNG A ; LEHR BW ; REICHENBACH JR.** Quantitative imaging of intrinsic magnetic tissue properties using MRI signal phase: An approach to in vivo brain iron metabolism?. *NeuroImage,* 2011, vol. 54, 2789-2807
- **KRÄMER M ; REICHENBACH JR.** Submillimeter fMRI at 3T Using Long Axis PROPELLER-EPI. *Proc. ISMRM 2012, #2862*
- **MAN LC ; PAULY JM ; MACOVSKI A.** Multifrequency interpolation for fast off-resonance correction. *Magn Reson Med,* 1997, vol. 37 (5), 785-792
- **XIANG QS ; YE FQ.** Correction for geometric distortion and N/2 ghosting in EPI by phase labeling for additional coordinate encoding (PLACE. *Magn Reson Med,* 2007, vol. 57 (4), 731-741
- **HOLLAND D ; KUPERMAN JM ; DALE AM.** Efficient correction of inhomogeneous static magnetic field-induced distortion in Echo Planar Imaging. *NeuroImage,* 2010, vol. 50 (1), 175-183
- **PIPE JG.** Magnetic Resonance Motion correction with PROPELLER MRI: application to head motion and free-breathing cardiac imaging. *Magn Reson Med,* 1999, vol. 42 (5), 963-969
- **SKARE S ; NEWBOULD RD ; CLAYTON DB ; BAMMER R.** Propeller EPI in the Other Direction. *Magn Reson Med.,* 2006, vol. 55 (6), 1298-1307
- **HUO D ; LI Z ; ABOUSSOUAN E ; KARIS JP ; PIPE JG.** Turboprop IDEAL: A Motion-Resistant Fat-Water Separation Technique. *Magn Reson Med,* 2009, vol. 61 (1), 188-195
- **POUSTCHI-AMIN M ; MIROWITZ SA ; BROWN JJ ; MCKINSTRY RC ; LI T.** Principles and Applications of Echo-planar Imaging: A Review for the General Radiologist. *Radiographics,* 2001, vol. 21, 767-779
- **BLAIMER M ; BREUER F ; MUELLER M ; HEIDEMANN RM ; GRISWOLD MA ; JAKOB PM.** SMASH, SENSE, PILS, GRAPPA - How to Choose the Optimal Method. *Top Magn Reson Imaging,* 2004, vol. 15 (4), 223-236